# EUROPÄISCHE PATENTANMELDUNG

(11) **EP 1 726 913 A1**
(43) Veröffentlichungstag der Anmeldung: **29.11.2006**
(21) Anmeldenummer: 06113362.5
(22) Anmeldetag: 02.05.2006
(51) Int. Cl.: G01B 11/06, G01B 11/24, H05K 13/04

(54) **Sensor und Sensorsystem zur optischen Erfassung von Objekten, Bestückkopf, Verfahren zur Bestimmung der Höhensposition eines Bauelements**

(30) Priorität: 23.05.2005 DE 102005023705
(71) Anmelder: SIEMENS AKTIENGESELLSCHAFT, 80333 München (DE)
(72) Erfinder: Burger, Stefan, 81379 München (DE)

(57) **Zusammenfassung**

Die Erfindung schafft einen Sensor zur optischen Erfassung von Objekten. Der Sensor umfasst ein punktförmiges optisches Sendeelement (322) zum Aussenden von Messlicht, ein flächiges optisches Empfangselement (328) zum Empfangen des Messlichts, und eine Auswerteeinheit, die ein in den Strahlengang zwischen Sendeelement (322) und Empfangselement (328) gebrachtes Objekt (180) anhand einer Abschattung des Messlichts erfasst. Die Erfindung schafft ferner ein Sensorsystem mit zwei Sensoren und Auswerteeinheiten sowie einem gemeinsamen Elektronik-Modul. Ferner wird ein Bestückkopf (350) zum Aufnehmen, Transportieren und Aufsetzen von Bauelementen (380) geschaffen, welcher einen Grundkörper (360), eine Bauelement-Haltevorrichtung (362) sowie einen Sensor aufweist. Außerdem wird ein Verfahren zur Bestimmung der Höhenposition eines von einer Haltevorrichtung (362) aufgenommenen Bauelements (380) angegeben, wobei der Sensor, das Sensorsystem oder der Bestückkopf verwendet wird. Das Bauelement (380) wird durch das Messlicht hindurch bewegt und dabei der zeitliche Verlauf eines analogen Ausgangssignals des Empfangselements (328) aufgezeichnet. Jeweils ein Wert des Ausgangssignals wird einer bestimmten Höhenposition des Bauelements (380) zugeordnet.

## Beschreibung

Die Erfindung betrifft einen Sensor und ein Sensorsystem zur optischen Erfassung von Objekten, insbesondere zur Anwesenheitskontrolle und/oder zur Positionsbestimmung von elektronischen Bauelementen, welche zum Zwecke der Bestückung auf einen Bauelementeträger von jeweils einer Haltevorrichtung eines Bestückkopfs aufgenommen sind. Die Erfindung betrifft ferner einen Bestückkopf zum Aufnehmen, Transportieren und Aufsetzen von Bauelementen auf einen zu bestückenden Bauelementeträger. Außerdem betrifft die Erfindung ein Verfahren zur Bestimmung der Höhenposition eines von einer Haltevorrichtung aufgenommenen Bauelements unter Verwendung eines oben genannten Sensors, eines oben genannten Sensorsystems oder eines oben genannten Bestückkopfes.

Bei der automatischen Bestückung von Bauelementeträgern durch einen Bestückautomaten werden von einem Bestückkopf, welcher eine oder eine Mehrzahl von Haltevorrichtungen aufweist, Bauelemente aus einer Bauelement-Zuführeinrichtung entnommen und in einen Bestückbereich transportiert, in welchem sich ein zu bestückender Bauelementeträger befindet. Die Bauelemente werden dann auf den Bauelementeträger an durch entsprechenden Anschlusskontakte vorgegebene Bauelement-Einbaupositionen aufgesetzt.

Infolge der zunehmenden Miniaturisierung von elektronischen Bauelementen erfordert ein erfolgreicher Bestückvorgang eine hohe Bestückgenauigkeit. Diese kann nur dadurch realisiert werden, dass nicht nur die Art sondern auch die Position der von jeweils einer Haltevorrichtung aufgenommenen Bauelemente mittels eines optischen Sensors genau erfasst wird. Eventuell vorhandene Positionsabweichungen der aufgenommenen Bauelemente können dann durch eine entsprechende Positionierung des Bestückkopfes kompensiert werden.

Aus der US 5,699,448 ist eine optische Messvorrichtung zum gleichzeitigen Erfassen von mehreren Bauelementen bekannt, welche von jeweils einer Haltevorrichtung eines Bestückkopfes aufgenommen sind. Die Messvorrichtung umfasst eine einzige Kamera, welche mit den Bauelementen über jeweils ein optisches Abbildungssystem gekoppelt ist. Die optischen Abbildungssysteme weisen jeweils ein Umlenkprisma, eine Linse und ein flexibles Bündel von Lichtwellenleitern auf, so dass die einzelnen Abbildungsstrahlengänge der voneinander beabstandeten Bauelemente derart zusammengeführt werden können, dass die Bauelemente jeweils von einem Teil des Gesichtsfeldes der Kamera erfasst werden können. Die optische Messvorrichtung hat den Nachteil, dass für jedes optische Abbildungssystem jeweils mehrere optische Komponenten benötigt werden, so dass die Messvorrichtung insgesamt relativ teuer ist. Ein weiterer Nachteil besteht darin, dass die Messvorrichtung nur schwer justiert werden kann.

Der Erfindung liegen die beiden Aufgaben zugrunde, einen Sensor und ein Sensorsystem zur optischen Erfassung von Objekten zu schaffen, welche preiswert hergestellt und zudem auf einfache Weise justiert werden können. Der Erfindung liegt ferner die dritte Aufgabe zugrunde, einen Bestückkopf zum Aufnehmen, Transportieren und Aufsetzen von Bauelementen zu schaffen, welcher auf einfache Weise eine optische Erfassung von aufgenommenen Bauelementen ermöglicht. Eine weitere Aufgabe der Erfindung besteht darin, ein Verfahren zur Bestimmung der Höhenposition eines von einer Haltevorrichtung aufgenommenen Bauelementes anzugeben, welches auf einfache Weise, d.h. mit einem geringen apparativen Aufwand durchgeführt werden kann und so eine Erhöhung der Bestückgenauigkeit und/oder der Prozesssicherheit ermöglicht.

Die erste der Erfindung zugrunde liegende vorrichtungsbezogene Aufgabe wird gelöst durch einen Sensor zur optischen Erfassung von Objekten, insbesondere zur Anwesenheitskontrolle und/oder zur Positionsbestimmung von elektronischen Bauelementen mit den Merkmalen des unabhängigen Anspruchs 1. Der erfindungsgemäße Sensor umfasst ein punktförmiges optisches Sendeelement, eingerichtet zum Aussenden von Messlicht, ein flächiges optisches Empfangselement, eingerichtet und angeordnet zum Empfangen des Messlichts, und eine dem Empfangselement nachgeschaltete Auswerteeinheit, welche derart eingerichtet ist, dass ein in den Strahlengang zwischen Sendeelement und Empfangselement gebrachtes Objekt anhand einer Abschattung des Messlichts erfassbar ist.

Der Erfindung liegt die Erkenntnis zugrunde, dass ein optischer Sensor, welcher lediglich zwei optische Elemente, nämlich das punktförmige optische Sensorelement und das flächige optische Empfangselement aufweist, auf vorteilhafte Weise in der Bestücktechnik angewendet werden kann. Der erfindungsgemäße Sensor beruht auf dem Prinzip einer Lichtschranke, bei der das zu erfassende Objekt einen Teil der von dem punktförmigen optischen Sendeelement ausgesandten Lichtintensität abschattet und ein verbliebener Rest an Lichtintensität, welcher auf das flächige Empfangselement trifft, gemessen und ausgewertet wird. Die Erfindung hat den Vorteil, dass keinerlei optische Komponenten, wie Linsen, Spiegel oder Prismen erforderlich sind, so dass der erfindungsgemäße Sensor nicht nur preiswert herzustellen ist, sondern auch eine einfache Justierung ermöglicht. Die einfache Justierung beruht in besonderer Weise darauf, dass bei einer vergleichsweise großen Fläche des Empfangselements kleine Objekte unabhängig von einem eventuell vorhandenen seitlichen Versatz immer voll auf die Detektorfläche des optischen Empfangselements abgebildet werden.

Da der erfindungsgemäße Sensor außer dem Sendeelement und dem Empfangselement keine weiteren optischen Komponenten aufweist, tritt durch die Kanten des zu erfassenden Objekts selbstverständlich eine gewisse Unschärfe bzw. eine gewisse Kantenverschmierung auf, welche proportional zu flächigen Ausdehnung des optischen Sendeelements ist. Aus diesem Grund wird gemäß der Erfindung ein zumindest annähernd punktförmiges optisches Sendeelement eingesetzt, so dass eine weitgehend scharfe Abbildung des zu erfassenden Objekts auf die Fläche des optischen Empfangselements erfolgt.

Gemäß Anspruch 2 umfasst der Sensor zusätzlich einen Lichtwellenleiter mit zwei Endflächen, wobei eine erste Endfläche mit einer Lichtquelle optisch gekoppelt ist und eine zweite Endfläche das punktförmige optische Sendeelement darstellt. Als Lichtwellenleiter wird bevorzugt eine Faser mit einem Kerndurchmesser im Bereich von 500 µm verwendet. Zudem kann die zweite Endfläche zu einer Mikrolinse gekrümmt sein, so dass das aus der zweiten Endfläche austretende Messlicht bevorzugt in Richtung des zu erfassenden Objekts abgestrahlt wird. Als Lichtquelle wird bevorzugt eine Leuchtdiode (LED) verwendet, welche zum einen eine sehr preiswerte Lichtquelle darstellt und zum anderen den Vorteil hat, dass bei einer geringen Wärmebelastung eine hohe Lichtausbeute erzielt wird.

Gemäß Anspruch 3 ist das flächige Empfangselement ein einkanaliger Lichtdetektor, beispielsweise eine Photodiode mit einer Fläche von ungefähr 2 x 2 mm². Bei einem entsprechenden Abstand zwischen dem optischen Sendeelement und dem optischen Empfangselement kann ein elektronisches Bauelement, welches beim Abholen bzw. beim Aufsetzen relativ zu dem Bestückkopf bewegt wird, während des gesamten Bewegungsvorgangs von dem Strahlengang des Messlichts erfasst werden.

Es wird darauf hingewiesen, dass alternativ selbstverständlich auch ein Detektor mit einer Ortsauflösung, beispielsweise ein Diodenarray verwendet werden kann. Dies hat den Vorteil, dass der genaue Ort des zu erfassenden Objekts durch eine Auswertung der auf die einzelnen Detektorpixel auftreffenden Lichtintensität ermittelt werden kann. Dies erfordert jedoch eine vergleichsweise aufwendige Auswertung einer Vielzahl von einzelnen Detektorsignalen.

Gemäß Anspruch 4 weist der Sensor zusätzlich eine Takterzeugungseinheit auf, welche mit dem Sendeelement derart gekoppelt ist, dass die Intensität des Messlichts mit einer vorgegebenen Frequenz variierbar ist. Als Takterzeugungseinheit eignet sich beispielsweise ein herkömmlicher Funktionsgenerator, mit dem die Intensität des Messlichts auf einfache Weise moduliert werden kann. Bei Verwendung eines entsprechenden Verstärkers (sog. Lock-In-Verstärker) ist der Sensor damit unempfindlich gegen Fremdlicht und gegen elektromagnetische Störungen, die beispielsweise von Antriebsmotoren für Haltevorrichtungen oder für eine Positioniereinrichtung des Bestückkopf erzeugt werden.

Die zweite der Erfindung zugrunde liegende vorrichtungsbezogene Aufgabe wird gelöst durch ein Sensorsystem mit den Merkmalen des unabhängigen Anspruchs 5. Das erfindungsgemäße Sensorsystem umfasst zumindest zwei Sensoren nach einem der vorangegangenen Ansprüche sowie ein Elektronik-Modul, welches die beiden Auswerteeinheiten der beiden Sensoren umfasst.

Der Erfindung liegt die Erkenntnis zugrunde, dass ein beiden Sensoren zugeordnetes gemeinsames Elektronik-Modul eine besonders preiswerte und kompakte Realisierung eines mehrkanaligen Sensorsystems ermöglicht.

Gemäß Anspruch 6 umfasst das Elektronik-Modul zusätzlich bevorzugt sämtliche elektronischen Komponenten, welche den beiden Sendeelementen und den beiden Empfangselementen zugeordnet sind. Elektronische Komponenten für das Sendeelement sind beispielsweise die Takterzeugungseinheit, Treiberschaltungen für Leuchtdioden sowie ggf. die Leuchtdioden selbst. Elektronische Komponenten für die Empfangselemente sind beispielsweise optische und/oder elektronische Filter, Verstärker, Gleichrichter und so genannte Multiplexer, welche eine Datenübertragung von mehreren optischen Empfangselementen über eine gemeinsame Datenleitung ermöglichen.

Bevorzugt weist das Sensorsystem eine vollständige modulare Trennung zwischen einem Optik-Modul und einem Elektronik-Modul auf, wobei sämtliche Komponenten des Sensorsystems in einem der beiden Module enthalten sind. Eine vollständige modulare Trennung erleichtert nicht nur die Handhabung des Sensorsystems, vielmehr ist das Sensorsystem auch durch die Möglichkeit verschiedene für unterschiedliche Anwendungen optimierte Module miteinander zu kombinieren, vielfältig einsetzbar.

Die dritte der Erfindung zugrunde liegende vorrichtungsbezogene Aufgabe wird gelöst durch einen Bestückkopf zum Aufnehmen, Transportieren und Aufsetzen von Bauelementen mit den Merkmalen des unabhängigen Anspruchs 7. Der erfindungsgemäße Bestückkopf umfasst einen Grundkörper, eine Haltevorrichtung zum temporären Aufnehmen eines Bauelements, welche Haltevorrichtung relativ zu dem Grundkörper entlang einer z-Achse verschiebbar ist, und einen oben genannten Sensor, wobei das Sendeelement und das Empfangselement auf unterschiedlichen Seiten der z-Achse angeordnet sind.

Der Erfindung liegt die Erkenntnis zugrunde, dass die Bewegung eines Bauelements insbesondere beim Aufnehmen des Bauelements aus einer Bauelement-Zuführvorrichtung und beim Aufsetzen des Bauelements auf einen zu bestückenden Bauelementeträger durch einen auf dem Prinzip einer Lichtschranke beruhenden Sensor verfolgt werden kann. Dabei hängt das Bauelement an einer Haltevorrichtung des Bestückkopfes und wird beim Aufnehmen und/oder beim Aufsetzen durch die verschiedenen Strahlengänge des Messlichts hindurch bewegt.

Der Sensor kann in unterschiedlichen Bestückköpfen, welche eine oder eine Mehrzahl von Haltevorrichtungen aufweisen, eingesetzt werden. Er ermöglicht eine preiswerte, schnelle und zuverlässige Erfassung sowohl der Anwesenheit eines Bauelements an einer Haltevorrichtung als auch der jeweiligen Position, insbesondere der Höhenposition des Bauelements und verbessert somit auf einfache Weise die Prozesssicherheit eines Bestückautomaten.

Die dritte der Erfindung zugrunde liegende vorrichtungsbezogene Aufgabe wird ebenfalls gelöst durch einen Bestückkopf zum Aufnehmen, Transportieren und Aufsetzen von Bauelementen mit den Merkmalen des unabhängigen Anspruchs 8. Der erfindungsgemäße Bestückkopf umfasst einen Grundkörper, zwei Haltevorrichtungen zum temporären Aufnehmen jeweils eines Bauelements, wobei die beiden Haltevorrichtungen relativ zu dem Grundkörper entlang einer z-Achse verschiebbar sind, und ein oben beschriebenes Sensorsystem, wobei jeweils ein Sendeelement und ein dem jeweiligen Sendeelement zugeordnetes Empfangselement auf unterschiedlichen Seiten einer z-Achse angeordnet sind.

Der Erfindung liegt die Erkenntnis zugrunde, dass ein mehrkanaliges Sensorsystem insbesondere für so genannte Matrixköpfe, welche eine Mehrzahl von Haltevorrichtungen aufweisen, die alle entlang einer z-Richtung verschiebbar sind, die Prozesssicherheit auf vorteilhafte und einfache Weise erhöht. Die Haltevorrichtungen eines Matrixkopfes können jeweils einen eigenen Antrieb aufweisen, so dass die einzelnen Haltevorrichtungen unabhängig voneinander entlang der z-Richtung bewegt werden können. Alternativ können die Haltevorrichtungen auch durch einen zentralen Antrieb bewegt werden, wobei eine quasi unabhängige Bewegung der einzelnen Haltevorrichtungen durch ein selektives Ankoppeln der jeweiligen Haltevorrichtung an den zentralen Antrieb ermöglicht wird.

Die der Erfindung zugrunde liegende verfahrensbezogene Aufgabe wird gelöst durch ein Verfahren zur Bestimmung der Höhenposition eines von einer Haltevorrichtung aufgenommenen Bauelements unter Verwendung eines oben genannten Sensors, eines oben genannten Sensorsystems oder eines oben genannten Bestückkopfes. Bei dem erfindungsgemäßen Verfahren wird die Haltevorrichtung mit dem Bauelement durch den Strahlengang eines Messlichts zwischen einem Sendeelement und einem Empfangselement hindurchbewegt und dabei der zeitliche Verlauf eines analogen Ausgangssignals des Empfangselements aufgezeichnet. Jeweils ein Wert des analogen Ausgangssignals wird einer Höhenposition des Bauelements zugeordnet.

Der Erfindung liegt die Erkenntnis zugrunde, dass die Höhenposition eines Bauelements bereits durch das analoge Ausgangssignal eines einkanaligen flächigen Empfangselements bei einer entsprechenden Auswertung des Signals ermittelt werden kann. Somit kann das erfindungsgemäße Verfahren bei einem geringen aparativen Aufwand mit preiswerten elektronischen und optischen Standardkomponenten durchgeführt werden.

Gemäß Anspruch 10 wird zusätzlich die Haltevorrichtung ohne ein aufgenommenes Bauelement durch den Strahlengang des Messlichts zwischen dem Sendeelement und dem Empfangselement hindurch bewegt und dabei ein weiterer zeitlicher Verlauf des analogen Ausgangssignals aufgezeichnet. Der zeitliche Verlauf wird mit dem weiteren zeitlichen Verlauf verglichen, wobei insbesondere durch eine Differenzbildung der den beiden Bewegungen zugeordneten Signalverläufe die Höhenposition des Bauelements besonders genau bestimmt werden kann. Gegebenenfalls vorhandene Positionstoleranzen einer parallel zu der Bewegungsrichtung verlaufenden z-Richtung werden auf diese Weise herausgemittelt.

Im Rahmen eines Bestückprozesses sind typische Bewegungen der Haltevorrichtung mit aufgenommenem Bauelement die Bewegung der Haltevorrichtung nach dem Abholen des Bauelements nach oben sowie die Aufsetzbewegung eines aufgenommenen Bauelements auf den zu bestückenden Bauelementeträger nach unten. Typische Bewegungen ohne Bauelement treten insbesondere durch die Bewegung der Haltevorrichtung unmittelbar vor dem Abholen des Bauelements sowie der Aufwärtsbewegung einer Haltevorrichtung unmittelbar nach dem Aufsetzen eines Bauelements auf einen Bauelementeträger auf.

Weitere Vorteile und Merkmale der vorliegenden Erfindung ergeben sich aus der folgenden beispielhaften Beschreibung derzeit bevorzugter Ausführungsformen.

In der Zeichnung zeigen in schematischen Darstellungen
- Figur 1: einen in zwei Module aufgeteilten Sensor zur optischen Erfassung von Objekten durch eine Abschattung von Messlicht,
- Figur 2: den Schattenwurf eines Messobjekts innerhalb der von einem punktförmigen optischen Sendeelement ausgesandten Strahlen eines Messlichts,
- Figur 3a: einen Bestückkopf mit zwei entlang einer z-Richtung verschiebbar gelagerten Haltevorrichtungen in einer Querschnittsansicht und
- Figur 3b: einen Bestückkopf mit sechs entlang einer z-Richtung verschiebbar gelagerten Haltevorrichtungen in einer perspektivischen Darstellung.

An dieser Stelle bleibt anzumerken, dass sich in der Zeichnung die Bezugszeichen von gleichen oder einander entsprechenden Komponenten lediglich in ihrer ersten Ziffer unterscheiden.

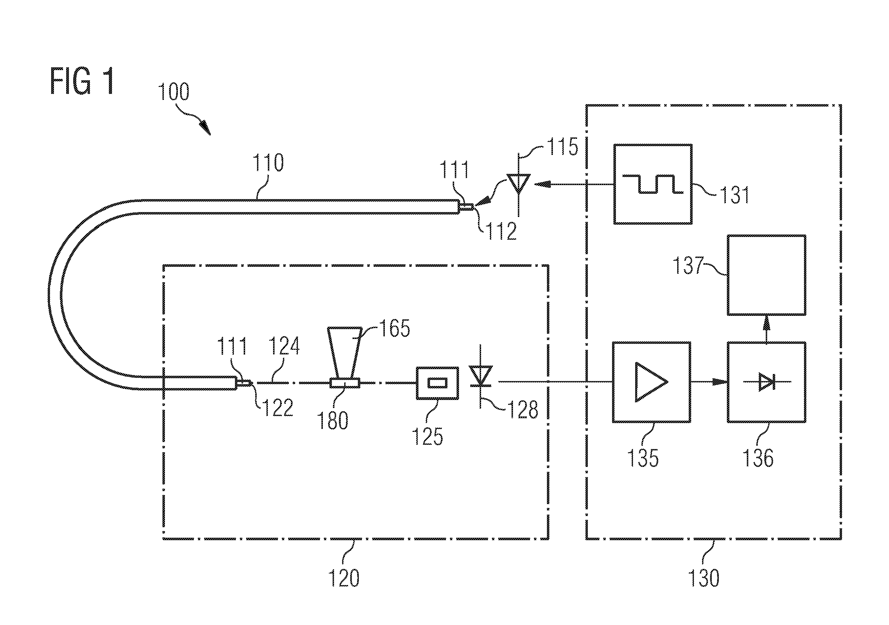

Der in Figur 1 dargestellte Sensor 100 dient der Positionserfassung eines Bauelements 180, welches von einer Haltevorrichtung 165 eines nicht dargestellten Bestückkopfes aufgenommen ist. Der Sensor umfasst ein Optik-Modul 120 sowie ein Elektronik-Modul 130, denen jeweils unterschiedliche optische bzw. elektronische Komponenten des Sensors 100 zugeordnet sind. Das Elektronik-Modul 130 umfasst als Takterzeugungseinheit einen Funktionsgenerator 131, welcher mit einer Leuchtdiode 115 derart elektronisch gekoppelt ist, dass entsprechend dem Ausgangssignal des Funktionsgenerators 131 die Leuchtdiode 115 in einer periodisch modulierten Weise Licht aussendet. Die Leuchtdiode 115 kann innerhalb oder auch außerhalb des Elektronik-Moduls 130 angeordnet sein.

Die Leuchtdiode 115 ist mit einem Lichtwellenleiter 110 optisch gekoppelt, wobei das von der Leuchtdiode 115 ausgesandte Licht über eine erste Endfläche 112 in einen Faserkern 111 des Lichtwellenleiters 110 eingekoppelt wird. Eine zweite Endfläche 122 des Lichtwellenleiters 110 ist dem Optik-Modul 120 zugeordnet und dient als optisches Sendeelement. Der Faserkern weist einen Durchmesser von 500 µm auf. Somit kann die Endfläche 122 als nahezu punktförmiges Sendeelement angesehen werden. Das Optik-Modul 120 weist ferner eine Blende 125 sowie eine flächige Photodiode 128 auf, welche unmittelbar hinter der Blende 125 angeordnet ist.

Bei einer Bewegung der Haltevorrichtung 165 relativ zu dem nicht dargestellten Bestückkopf beispielsweise während eines Abholens eines Bauelements von einer Bauelement-Zuführeinrichtung oder während eines Aufsetzens eines Bauelements auf einen ebenfalls nicht dargestellten Bauelementeträger wird das Bauelement 180 durch den Strahlengang des von der zweiten Endfläche ausgesandten Messlichts bewegt. Dieser Strahlengang verläuft entlang einer optischen Achse 124. Sobald sich das Bauelement 180 in den Messbereich bewegt, welcher durch das zumindest annähernd punktförmige optische Sendeelement 122 und durch die Blendenöffnung der Blende 125 bestimmt ist, erfolgt eine teilweise Abschattung des auf die Photodiode 128 treffenden Messlichts.

Die Photodiode 128 ist an einen Verstärker 135 angeschlossen, welcher dem Elektronik-Modul 130 zugeordnet ist. Dem Verstärker 135 ist ein Gleichrichter 136 nachgeschaltet, welcher ein analoges Ausgangssignal an eine Auswerteeinheit 137 liefert, wobei das Ausgangssignal direkt proportional zu der Lichtmenge des durch die Blendenöffnung 125 und auf die Fotodiode 128 treffenden Messlichts ist. Aus diesem Ausgangssignal wird mittels der Auswerteeinheit 137 die Anwesenheit des Bauelements 180 innerhalb des geometrisch optischen Messbereichs bzw. die Position des Bauelements 180 innerhalb dieses Messbereichs bestimmt.

Der Sensor 100, welcher durch einfache elektronische und optische Standardkomponenten auf preiswerte Art und Weise realisiert werden kann, hat den Vorteil, dass das optische Sendeelement 122 sowie das optische Empfangselement 128 vollständig elektromagnetisch entkoppelt sind. Dies verringert die Störanfälligkeit des Sensors 100 erheblich. Störende Fremdlichteinflüsse werden durch eine durch den Funktionsgenerator 131 bestimmte Modulation der Lichtintensität des Messlichts unterdrückt, sofern der Verstärker 135 derart eingerichtet ist, dass lediglicht diejenigen Frequenzanteile des von der Fotodiode 128 erzeugten Messsignals verstärkt werden, welche mit der Frequenz der Lichtmodulation übereinstimmen.

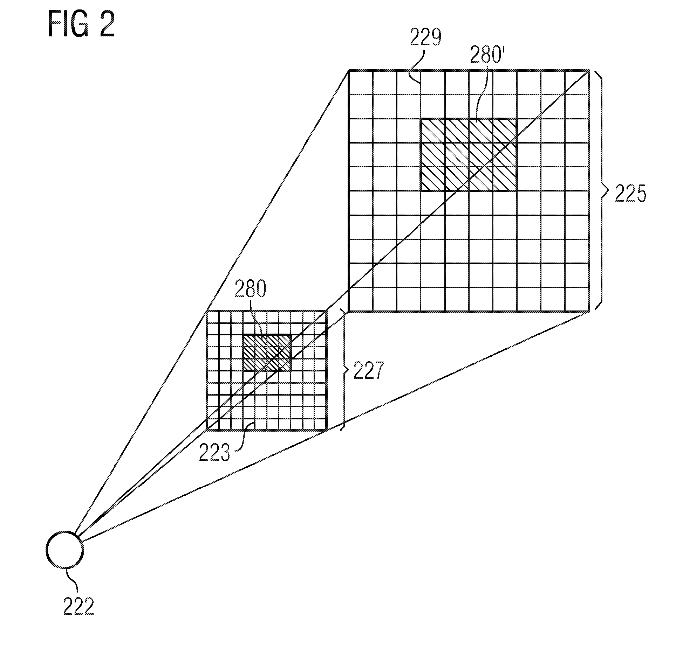

Das dem optischen Sensor 100 zugrunde liegende Prinzip des Schattenwurfs auf einer Empfängerfläche 225 wird im Folgenden anhand von Figur 2 erläutert. Die Geometrie des entsprechenden Sensors wird dabei durch die relative Lage zwischen einem zumindest annähernd punktförmigen Sendeelement 222, einem Messbereich 227 sowie der Empfängerfläche 225 bestimmt. Der Messbereich 227 ergibt sich dabei durch die Randstrahlen des von dem Sendeelement 222 ausgesandten Messlichts, welche gerade noch in die Ecken der Empfängerfläche 225 treffen. Der Messbereich 227 ist durch eine Vielzahl von Gitterlinien 223 dargestellt.

Ein zu erfassendes Objekt 280, welches sich in dem Messbereichs 227 befindet, führt zu einem Schattenwurf auf der Empfängerfläche 225, welche ebenfalls durch eine Vielzahl von Gitterlinien 229 dargestellt ist. Abhängig von der Lage des Messbereichs 227 in den Bereich zwischen Sendeelement 222 und Empfängerfläche 225 wird ein mehr oder weniger vergrößerter Schattenwurf 280' des Messobjekts 280 erzeugt.

Bei einem Eintauchen des Messobjekts 280 in den Messbereich 227 nimmt somit die Lichtmenge, welche auf die Empfängerfläche 225 trifft, zunächst kontinuierlich ab, bis sich das Messobjekt 280 vollständig in dem Messbereich befindet. Solange sich das Messobjekt 280 vollständig innerhalb des Messbereichs 227 befindet, bleibt die auf die Empfängerfläche 225 auftreffende Lichtmenge konstant. Erst wenn sich das Messobjekt 280 wieder zumindest teilweise außerhalb des Messbereichs 227 bewegt, nimmt die auf die Empfängerfläche 225 treffende Lichtmenge und damit auch das Ausgangssignal eines entsprechenden flächigen Lichtdetektors wieder zu.

Es wird darauf hingewiesen, dass bei der Auswertung des entsprechenden Ausgangssignals selbstverständlich die Abschattung durch eine in Figur 2 nicht dargestellte Haltevorrichtung für das Messobjekt 280 berücksichtigt werden muss. Da jedoch die Geometrie der verwendeten Haltevorrichtungen genau bekannt ist, kann die Abschattung durch die Haltevorrichtung ohne größere Schwierigkeiten berücksichtigt werden.

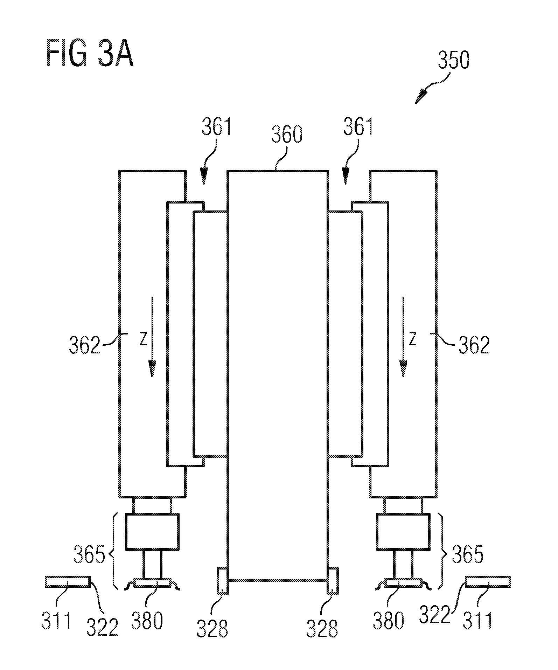

Figur 3a zeigt ein an einen Bestückkopf 350 angebrachtes Sensorsystem, welches zwei Sensoren aufweist, die jeweils einen Lichtwellenleiter 311 mit einer als Sendeelement dienenden Lichtwellenleiter-Endfläche 322 sowie eine als Empfangselement dienende flächige Photodiode 328 aufweisen. Die Lichtwellenleiter 311 sind über nicht dargestellte Haltevorrichtungen relativ zu dem Grundkörper 360 des Bestückkopfs 350 in einer festen räumlichen Position angeordnet, so dass sich die entsprechenden Messbereiche, die von jeweils einer Lichtwellenleiter-Endfläche 322 und einer entsprechenden Photodiode 328 bestimmt werden, relativ zu dem Bestückkopf in einer festen räumlichen Lage befinden. Eine Blende zwischen Sendeelement 322 und Photodiode 328 ist gemäß dem hier dargestellten Ausführungsbeispiel nicht vorgesehen. Vielmehr wirkt die Begrenzung der flächigen Photodiode 328 als Blende.

Der Bestückkopf 350 umfasst einen Grundkörper 360, an welchem zwei hohle Schäfte 362 angebracht sind, welche jeweils über eine Linearführung 361 und einem nicht dargestellten Antrieb entlang einer z-Achse bewegt werden können. An dem hohlen Schaft 362 befindet sich jeweils eine Haltevorrichtung 365 zur temporären Aufnahme eines Bauelements 380, welches bei einer entsprechenden Bewegung der Haltevorrichtung 365 in den Messbereich zwischen einem Sendeelement 322 und einem entsprechenden Empfangselement 328 gebracht wird. Die Erzeugung des Messlichts, welches aus der zweiten Endfläche 322 austritt, und die Verarbeitung des Detektorsignals, welches von der Photodiode 328 ausgegeben wird, erfolgt entsprechend der in Figur 1 dargestellten Art und Weise und wird an dieser Stelle nicht noch einmal im Detail erläutert.

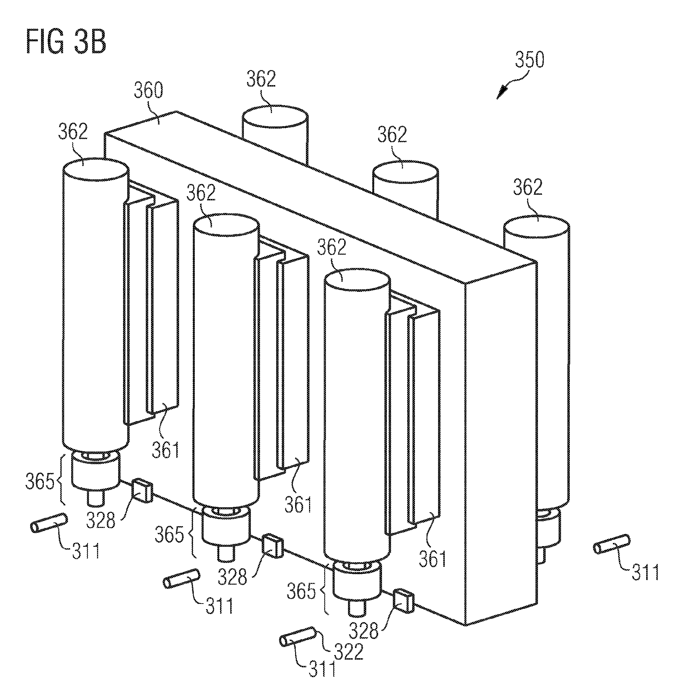

Figur 3b zeigt in einer perspektivischen Darstellung einen Bestückkopf 350, welcher einen Grundkörper 360 aufweist, an dem insgesamt sechs hohle Schäfte 362 angeordnet sind. An jedem hohlen Schaft 362 befindet sich eine Haltevorrichtung 365 zur temporären Aufnahme eines in Figur 3b nicht dargestellten Bauelements. Entsprechend der Anzahl an Haltevorrichtungen 365 weist der Bestückkopf 350 insgesamt sechs Lichtwellenleiter 311 auf, denen jeweils eine Photodiode 328 zugeordnet ist, so dass sämtliche Bauelemente, die von dem Bestückkopf 350 aufgenommen werden können, hinsichtlich ihrer räumlichen Lage relativ zu dem Grundkörper 360 vermessen werden können.

### Bezugszeichenliste

- 100: Sensor
- 110: Lichtwellenleiter
- 111: Faserkern
- 112: erste Endfläche
- 115: Leuchtdiode
- 120: Optik-Modul
- 122: zweite Endfläche (Sendeelement)
- 124: optische Achse
- 125: Blende
- 128: Photodiode (Empfangselement)
- 130: Elektronik-Modul
- 131: Funktionsgenerator (Takterzeugungseinheit)
- 135: Verstärker
- 136: Gleichrichter
- 137: Auswerteeinheit
- 165: Haltevorrichtung
- 180: Bauelement

- 222: zweite Endfläche (Sendeelement)
- 223: Gitterlinie Messfläche
- 225: Empfängerfläche
- 227: Messbereich
- 229: Gitterlinie Empfangsfläche
- 280: Messobjekt
- 280': vergrößerte Abbildung Messobjekt

- 311: Lichtwellenleiter
- 322: zweite Endfläche (Sendeelement)
- 328: Photodiode (Empfangselement)
- 350: Bestückkopf
- 360: Grundkörper
- 361: Linearführung
- 362: hohler Schaft
- 365: Haltevorrichtung
- 380: Bauelement

## Patentansprüche

1. Sensor zur optischen Erfassung von Objekten, insbesondere zur Anwesenheitskontrolle und/oder zur Positionsbestimmung von elektronischen Bauelementen (180), mit
• einem punktförmigen optischen Sendeelement (122), eingerichtet zum Aussenden von Messlicht,
• einem flächigen optischen Empfangselement (128), eingerichtet und angeordnet zum Empfangen des Messlichts, und
• einer dem Empfangselement (128) nachgeschalteten Auswerteeinheit (137), welche derart eingerichtet ist, dass ein in den Strahlengang zwischen Sendeelement (122) und Empfangselement (128) gebrachtes Objekt (180) anhand einer Abschattung des Messlichts erfassbar ist.

2. Sensor nach Anspruch 1, zusätzlich mit
einem Lichtwellenleiter (110), welcher zwei Endflächen (112, 122) aufweist, wobei
• eine erste Endfläche (112) mit einer Lichtquelle (115) optisch gekoppelt ist und
• eine zweite Endfläche (122) das punktförmige optische Sendeelement darstellt.

3. Sensor nach einem der Ansprüche 1 bis 2, bei dem
das flächige Empfangselement ein einkanaliger Lichtdetektor (128) ist.

4. Sensor nach einem der Ansprüche 1 bis 3, zusätzlich mit einer Takterzeugungseinheit (131), welche mit dem Sendeelement (122) gekoppelt ist, so dass die Intensität des Messlichts mit einer vorgegebenen Frequenz variierbar ist.

5. Sensorsystem, mit
• einem ersten Sensor (100) nach einem der Ansprüche 1 bis 4 zur Erfassung eines ersten Objekts (180),
• einem zweiten Sensor (100) nach einem der Ansprüche 1 bis 4 zur Erfassung eines zweiten Objekts (180), und
• einem Elektronik-Modul (130), welches
- die Auswerteeinheit (137) des ersten Sensors (100) und
- die Auswerteeinheit (137) des zweiten Sensors (100) umfasst.

6. Sensorsystem nach Anspruch 5, wobei
das Elektronik-Modul (130) zusätzlich
• erste elektronische Komponenten (131), welche den beiden Sendeelementen (122) zugeordnet sind, und
• zweite elektronische Komponenten (135, 136), welche den beiden Empfangselementen (128) zugeordnet sind,
umfasst.

7. Bestückkopf zum Aufnehmen, Transportieren und Aufsetzen von Bauelementen, mit
• einem Grundkörper (360),
• einer Haltevorrichtung (365) zum temporären Aufnehmen eines Bauelements (380), welche Haltevorrichtung (365) relativ zu dem Grundkörper (360) entlang einer z-Achse verschiebbar ist, und
• einem Sensor (100) nach einem der Ansprüche 1 bis 4, wobei das Sendelement (122) und das Empfangselement (128) auf unterschiedlichen Seiten der z-Achse angeordnet sind.

8. Bestückkopf zum Aufnehmen, Transportieren und Aufsetzen von Bauelementen, mit
• einem Grundkörper (360),
• einer ersten Haltevorrichtung (365) zum temporären Aufnehmen eines ersten Bauelements (380), welche erste Haltevorrichtung (365)
relativ zu dem Grundkörper (360) entlang einer ersten z-Achse verschiebbar ist,
• einer zweiten Haltevorrichtung (365) zum temporären Aufnehmen eines zweiten Bauelements (380), welche zweite Haltevorrichtung (365)
relativ zu dem Grundkörper (360) entlang einer zweiten z-Achse verschiebbar ist, und
• einem Sensorsystem nach einem der Ansprüche 5 bis 6, wobei jeweils ein Sendelement (322) und ein dem jeweiligen Sendeelement (322) zugeordnetes Empfangselement (328) auf unterschiedlichen Seiten einer z-Achse angeordnet sind.

9. Verfahren zur Bestimmung der Höhenposition eines von einer Haltevorrichtung (365) aufgenommenen Bauelementes (380) unter Verwendung
- eines Sensors nach einem der Ansprüche 1 bis 4,
- eines Sensorsystems nach einem der Ansprüche 5 bis 6, oder
- eines Bestückkopfes nach einem der Ansprüche 7 oder 8,
bei dem
• die Haltevorrichtung (365) mit dem Bauelement (380) durch den Strahlengang eines Messlichts zwischen einem Sendeelement (322) und einem Empfangselement (328) hindurch bewegt wird,
• dabei der zeitliche Verlauf eines analogen Ausgangssignals des Empfangselements (328) aufgezeichnet wird, und
• jeweils ein Wert des analogen Ausgangssignals einer Höhenposition des Bauelementes (380) zugeordnet wird.

10. Verfahren nach Anspruch 9, bei dem
zusätzlich
• die Haltevorrichtung (365) ohne das Bauelement (380) durch den Strahlengang des Messlichts zwischen dem Sendeelement (322) und dem Empfangselement (328) hindurch bewegt wird,
• dabei ein weiterer zeitlicher Verlauf des analogen Ausgangssignals aufgezeichnet wird, und
• der zeitliche Verlauf mit dem weiteren zeitlichen Verlauf verglichen wird.
